# FASCICULE DE BREVET EUROPEEN

(11) **EP 2 491 412 B1**
(45) Date de publication et mention de la délivrance du brevet: **16.03.2016**
(21) Numéro de dépôt: 10765645.6
(22) Date de dépôt: 18.10.2010
(51) Int. Cl.: G01S 3/808, G01R 31/08

(54) **PROCÉDÉ DE DÉTECTION DE LA POSITION D'UN FRONT D'ONDE CORRESPONDANT À UN ÉVÈNEMENT DANS UN SIGNAL REÇU PAR UN DÉTECTEUR**
VERFAHREN ZUR DETEKTION EINER WELLENFRONT ENTSPRECHEND EINES EREIGNISSES IN EINEM VON EINEM DETEKTOR EMPFANGENEN SIGNAL
METHOD FOR DETECTING A WAVEFRONT CORRESPONDING TO AN EVENT IN A SIGNAL RECEIVED BY A DETECTOR

(30) Priorité: 20.10.2009 FR 0957351
(43) Date de publication de la demande: 29.08.2012
(73) Titulaire: ALSTOM Technology Ltd, 5400 Baden (CH)
(72) Inventeur: LEBRETON, Raphaël, F-91310 Montlhery (FR)
(74) Mandataire: Ilgart, Jean-Christophe
(86) Numéro de dépôt international: PCT/EP2010/065592
(87) Numéro de publication internationale: WO 2011/048036

(56) Documents cités:
- EP-A1- 1 615 049
- EP-A1- 2 098 877
- US-A1- 2006 015 277

## Description

### DOMAINE TECHNIQUE

La présente invention concerne un procédé de détection de la position d'un front d'onde traduisant l'apparition d'un événement recherché, dans un signal temporel reçu par un détecteur, même si ce signal se propage dans un environnement pollué par des bruits et que le détecteur reçoit également les bruits ces derniers se superposant au signal. Le signal peut être un signal acoustique, un signal électromagnétique tel un signal radioélectrique ou encore un signal électromécanique tel une vibration provenant d'un organe électromécanique d'un appareil. L'événement recherché peut être par exemple une décharge partielle dans un appareil électrique, l'activation d'une source vocale dans un espace, une transitoire de pression dans pipeline ou autre.

La présente invention est utilisable notamment dans les procédés de détection et de localisation de sources de décharges partielles dans un appareil électrique tel un transformateur de puissance, une machine électrique. Les décharges partielles dans les appareils électriques sont associées à l'émission d'un signal acoustique (généralement ultrasonore). Le front d'onde dans le signal matérialise donc l'apparition de la décharge partielle et donc un défaut. Par front d'onde, on désigne la partie d'une onde située entre un point virtuel d'amplitude donnée et une valeur de crête supérieure à l'amplitude donnée qui suit immédiatement ce point virtuel d'amplitude donnée. Le signal temporel à surveiller est monotone avant l'apparition du front d'onde. Mais si ce signal est noyé dans du bruit ambiant, le bruit ambiant amène des pics localisés en amont du front d'onde et ils peuvent être pris pour des fronts d'ondes du signal reçu par le déteeteur.

Cette application aux appareils électriques n'est pas limitative, bien d'autres applications pourraient être concernées par exemple dans le domaine du sonar, ou la localisation d'une source vocale dans un espace, la surveillance des pipelines.

### ÉTAT DE LA TECHNIQUE ANTÉRIEURE

On connait, par exemple dans la demande de brevet FR 2 883 979 ou dans le brevet US 5 388 445 des méthodes de détection de pics, c'est-à-dire de front d'onde dans un signal temporel, basées sur le fenêtrage du signal, sur la détermination d'un indicateur approprié au signal, calculé dans chaque fenêtre et d'un seuil et sur une comparaison de l'indicateur et du seuil, un front d'onde étant détecté lorsque l'indicateur dépasse le seuil. Dans le brevet US 5 388 445, l'indicateur est une pente. Dans la demande de brevet FR 2 883 979, l'indicateur est la moyenne quadratique de l'énergie du signal. Le seuil employé lors d'une comparaison dépend de l'indicateur déterminé sur des fenêtres antérieurs à celle dans laquelle la comparaison va avoir lieu. La demande de brevet EP 1 615 049 A décrit un procédé permettant de réduire la charge de calcul occasionnée par la corrélation multicopies. A cet effet le procédé effectue une opération de corrélation multicopies. Ces méthodes permettent dans un grand nombre de cas de détecter la position d'un front d'onde dans le signal, mais aucune vérification n'est faite pour s'assurer que le front d'onde détecté correspond à l'événement recherché, en l'occurrence dans ces documents, une décharge partielle ou une transitoire de pression. Il se peut que le front d'onde détecté corresponde à du bruit.

En outre, si le signal reçu par le détecteur est très bruité, le seuil risque d'avoir une amplitude supérieure à l'amplitude maximale du signal et aucune détection ne sera possible. De plus, si le signal reçu par le détecteur est parasité par du bruit à basse fréquence, le front d'onde recherché ne pourra pas être détecté non plus, car il aura une amplitude inférieure à l'amplitude maximale du signal porté par le bruit à basse fréquence. Ainsi avec une seule recherche de l'apparition d'un front d'onde, il n'est pas possible d'être sûr que ce front d'onde, s'il est détecté, corresponde à l'événement recherché.

### EXPOSÉ DE L'INVENTION

La présente invention a justement comme but de proposer un procédé de détection de la position d'un front d'onde traduisant l'apparition d'un événement recherché dans un signal temporel reçu par un détecteur, ce procédé étant beaucoup plus fiable que dans l'art antérieur même si le bruit dans le signal reçu par le détecteur est réparti sur une grande plage de fréquences.

L'idée de base est de filtrer plusieurs fois le signal reçu par le détecteur avec un filtre passe-bande en faisant varier la taille de la bande passante du filtre passe-bande. L'application du filtre passe-bande va retarder le signal filtré de manière exponentielle, plus la taille de la bande passante décroit. Chacun des signaux filtrés va subir un traitement de recherche de front d'onde. Tous les fronts d'ondes identifiés vont être regroupés pour voir s'ils suivent une asymptote exponentielle. La position du front d'onde correspondant à l'événement recherché sera trouvée à l'aide de l'asymptote exponentielle.

Plus précisément, la présente invention est un procédé de détection de la position d'un front d'onde, traduisant l'apparition d'un événement recherché, dans un signal temporel reçu par un détecteur dans lequel :
on numérise le signal reçu par le détecteur pour obtenir un signal de travail,
on filtre le signal de travail N4 fois (N4 nombre entier supérieur ou égal à trois) avec un filtre passe-bande en faisant varier N4 fois la largeur de la bande passante du filtre passe-bande, les N4 bandes passantes étant contenues les unes dans les autres de la plus large à la plus étroite, de manière à obtenir N4 signaux de travail filtrés,
on traite chacun des N4 signaux de travail filtrés avec une méthode de détection de pics, pour détecter pour chacun, une position d'un premier front d'onde en termes d'instant d'arrivée,
on associe à chaque instant d'arrivée la largeur de la bande passante avec laquelle le signal de travail a été filtré,
on définit N4 points ayant chacun une ordonnée qui est un des instants d'arrivée et une abscisse qui est la largeur de la bande associée,
on place les N4 points dans un repère cartésien,
on recherche une asymptote exponentielle dans laquelle s'inscrit un maximum des N4 points, la position du front d'onde traduisant l'apparition de l'événement recherché étant l'ordonnée d'un point qui se trouve sur ou quasiment sur l'asymptote exponentielle et qui possède l'abscisse la plus grande.

Pour déterminer les bandes passantes extrêmes du filtre passe-bande, on peut calculer une transformée de Fourier discrète possédant N1 échantillons du signal de travail (N1 nombre entier) et l'utiliser pour définir les bornes de la bande passante la plus étroite et les bornes de la bande passante la plus large.

Plus précisément pour définir les bornes basse et haute de la bande passante la plus étroite et de la bande passante la plus large, on peut sélectionner dans la transformée de Fourier discrète, les N2 échantillons ayant la plus grande amplitude (N2 nombre entier inférieur à N1), et attribuer à la bande passante la plus étroite une borne basse qui est la fréquence la plus basse des N2 échantillons et une borne haute qui est la fréquence la plus haute des N2 échantillons, et sélectionner dans la transformée de Fourier discrète les N3 échantillons ayant la plus grande amplitude (N3 nombre entier bien plus grand que N2 mais inférieur à N1), et attribuer à la bande passante la plus large une borne basse qui est la fréquence la plus basse des N3 échantillons et une borne haute qui est la fréquence la plus haute des N3 échantillons. On vérifie deux conditions à savoir que la bande passante la plus large et la bande passante la plus étroite ont au moins une borne basse ou une borne haute distincte et que la bande passante la plus étroite est contenue dans la bande passante la plus large, si ce n'est pas le cas, on décale au moins l'une des bornes de la bande passante la plus étroite et/ou de la bande passante la plus large pour satisfaire aux deux conditions.

Il est préférable de lisser la transformée de Fourier discrète avant de définir les bornes de la bande passante la plus étroite et les bornes de la bande passante la plus large, cela permet d'éliminer du bruit.

On prévoit en plus des bandes passantes extrêmes, une ou plusieurs bandes passantes intermédiaires contenues les unes dans les autres en subdivisant un premier intervalle, s'il existe, entre la borne basse de la bande passante la plus large et la borne basse de la bande passante la plus étroite en N+1 parties (N nombre entier supérieur ou égal à un) et/ou en subdivisant un second intervalle, s'il existe, entre la borne haute de la bande passante la plus large et la borne haute de la bande passante la plus étroite en N+1 parties, une interface existant entre deux parties voisines du premier intervalle, cette interface formant une borne basse d'une bande passante intermédiaire et une interface existant entre deux parties voisines du second intervalle, cette interface formant une borne haute d'une bande passante intermédiaire.

Pour faciliter la recherche de l'asymptote exponentielle, lors du placement des N4 points dans le repère cartésien, on peut translater l'ordonnée des N4 points d'une grandeur de manière que le point ayant l'ordonnée la plus petite ait une ordonnée presque nulle après la translation.

Dans ce cas, on corrige la position du front d'onde correspondant à l'événement recherché en lui ajoutant la grandeur de translation.

Lorsque l'on dispose d'un grand nombre de points, il est possible pour faciliter la recherche de l'asymptote exponentielle, avant l'étape de recherche d'asymptote exponentielle, de sélectionner des points d'un triplet de points ayant des abscisses successives croissantes, de vérifier si les ordonnées de ces trois points sont bien décroissantes, si un des points du triplet ne vérifie pas cette décroissance en ordonnée de l'éliminer et de réitérer cette vérification de proche en proche avec un triplet suivant ayant au moins un point du triplet précédent.

Il est prudent, d'arrêter la comparaison dès que le nombre de points éliminés atteint N4/2 pour pouvoir construire une asymptote exponentielle la plus réaliste possible.

Le procédé selon l'invention est particulièrement adapté si l'événement recherché est une décharge partielle émise par une source de décharge partielle se trouvant dans un appareil électrique placé dans une enceinte contenant un fluide acoustiquement conducteur, le détecteur étant un détecteur acoustique.

### BRÈVE DESCRIPTION DES DESSINS

La présente invention sera mieux comprisse, à la lecture de la description d'exemples de réalisation donnés, à titre purement indicatif et nullemént limitatif, en faisant référence aux dessins annexés sur desquels:
la figure 1 donne l'allure d'un signal temporel auquel peut s'appliquer le procédé de l'invention ;
les figures 2A, 2B montrent respectivement la transformée de Fourier discrète et la transformée de Fourier discrète lissée d'un signal temporel auquel peut s'appliquer le procédé de l'invention;
la figure 3 montre la transformée de Fourier discrète lissée de la figure 2B portant les bandes passantes extrêmes et leurs bornes basses et hautes ;
la figure 4 montre l'imbrication des bandes passantes extrêmes et des bandes passantes intermédiaires du filtre passe-bande ;
les figures 5A, 5B, 5C montrent le tracé de l'asymptote exponentielle ;
la figure 6A montre un signal de travail très bruité mesuré sur site, la figures 6B un signal de travail bruité mesuré en usine, la figure 6C un zoom du signal de la figure 6B, les figures 6D et 6E des signaux de travail peu bruités mesurés en laboratoire, la flèche indiquant la position du front d'onde détecté par un procédé conventionnel avec filtrage unique ;

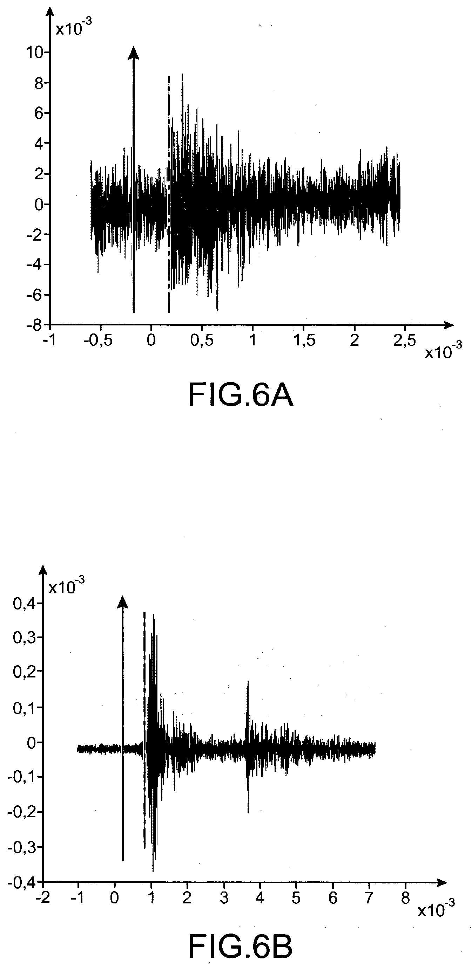

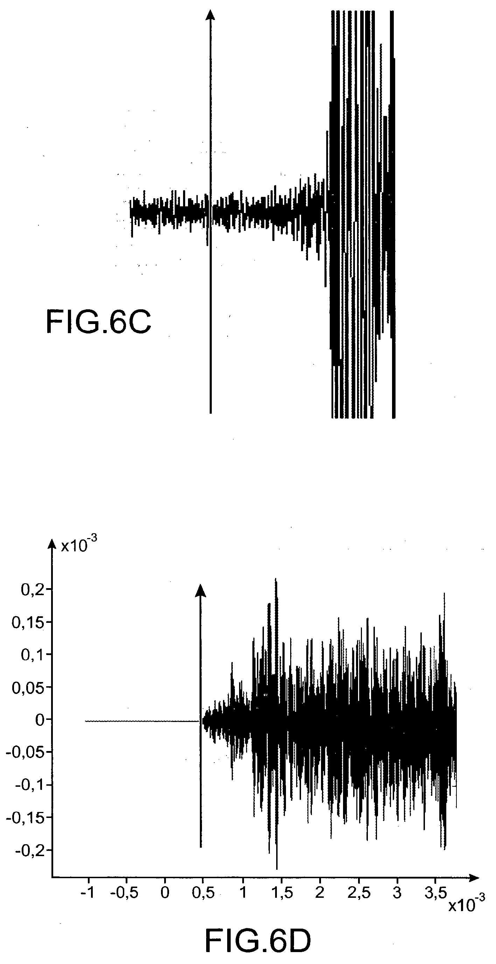

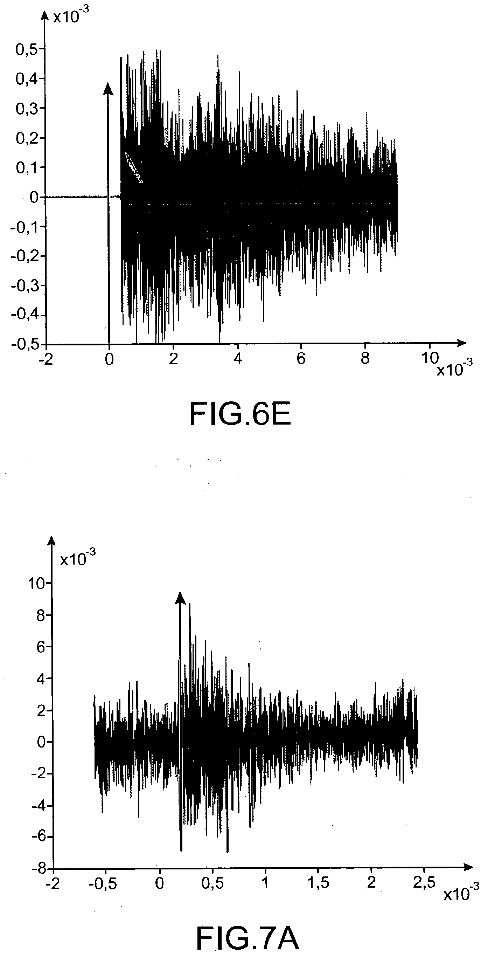

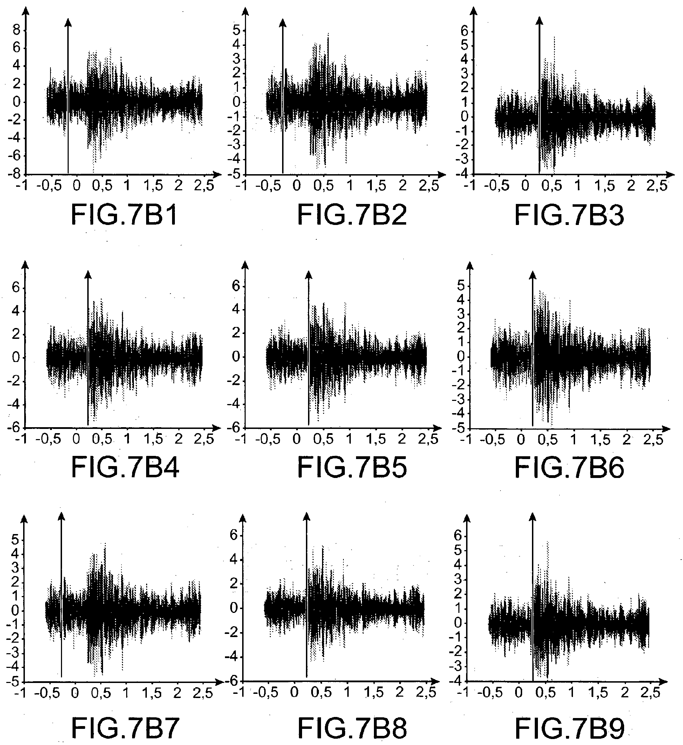

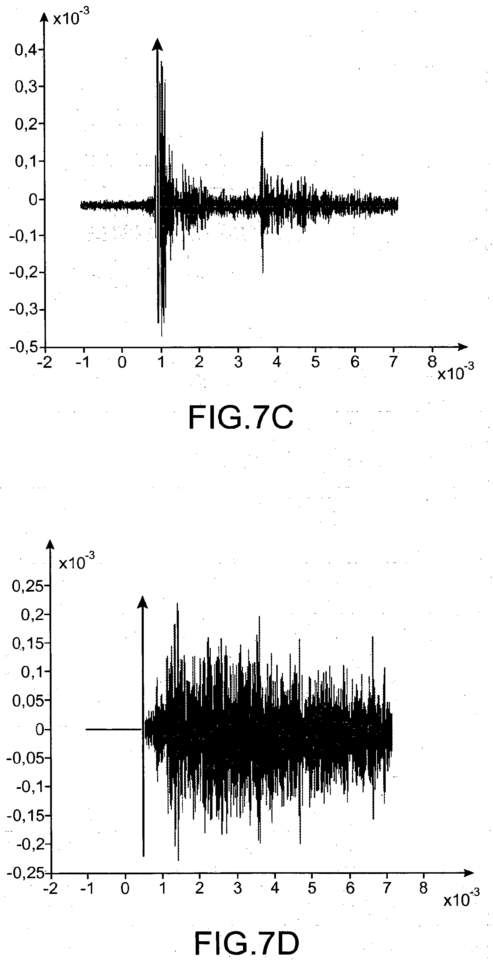

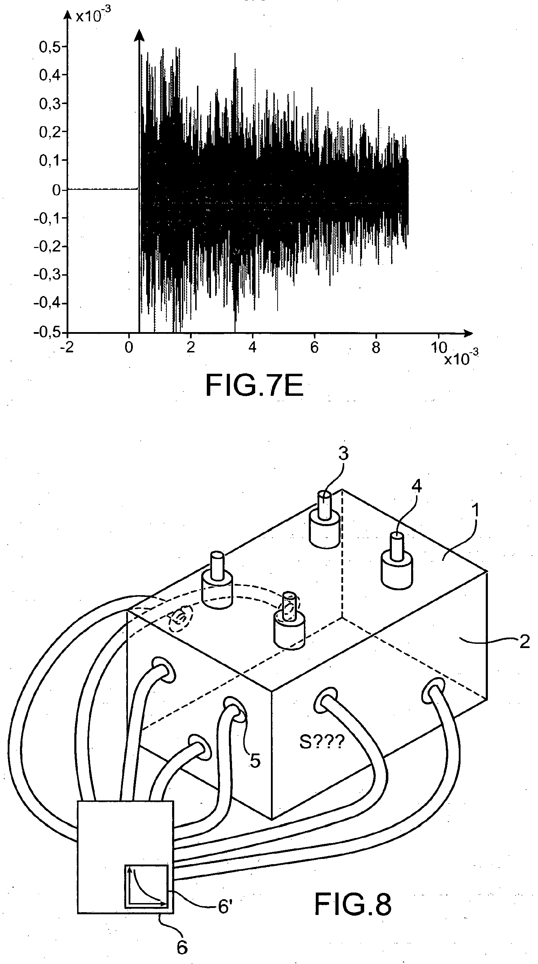

la figure 7A montre le signal de travail très bruité mesuré sur site de la figure 6A, les figures 7B1 à 7B9 le même signal de travail très bruité, mesuré sur site, filtré avec des bandes passantes différentes imbriquées les unes dans les autres, la figure 7C montre le signal de travail bruité mesuré en usine de la figures 6B, les figures 7D et 7E les signaux de travail peu bruités mesurés en laboratoire des figures 6D et 6E, la flèche indiquant la position du front d'onde détectée sur la fïgure 7A et les figures 7B1 à 7B9 à l'issue d'un seul filtrage et sur les figures 7C, 7D, 7E par le procédé de l'invention ;
la figure 8 montre un transformateur de puissance auquel on applique le procédé de l'invention.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

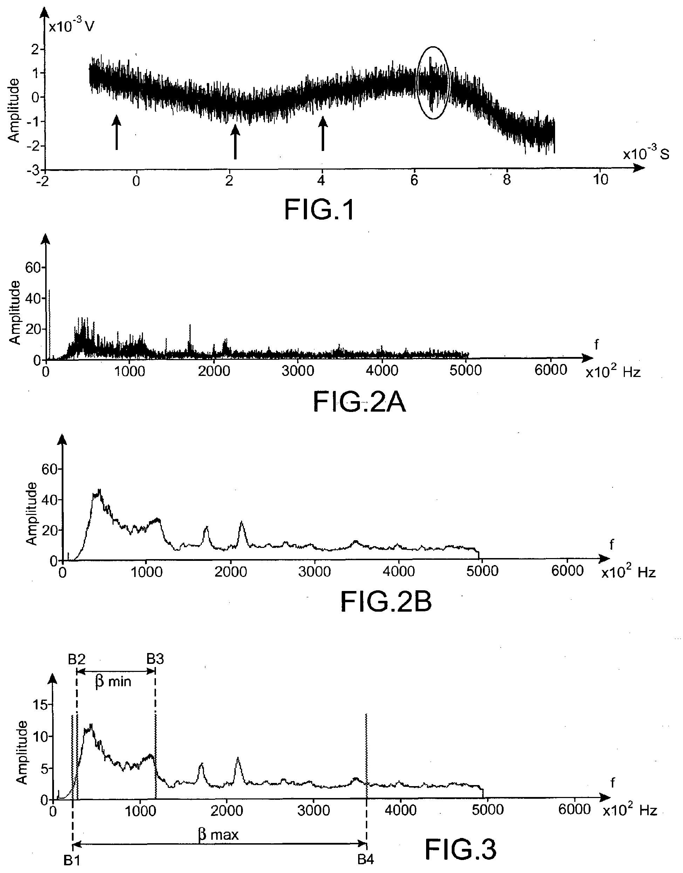

On a représenté sur la figure 1 un signal temporel, par exemple de type acoustique, à analyser et acquis par un détecteur. Dans ce signal, on désire détecter la position d'un front d'onde correspondant à la survenue d'un événement recherché, par exemple, l'instant d'apparition d'une décharge partielle prenant naissance dans un appareil électrique.

S'il s'agit d'un transformateur de puissance 1, par exemple, comme représenté sur la figure 8, il est généralement logé dans une enceinte 2 contenant un fluide conducteur tel que de l'huile ou de l'hexafluorure de soufre. Le détecteur 5 est placé à l'extérieur de l'enceinte 2 en contact avec l'une de ses parois. Il peut s'agir d'un détecteur 5 à ultrasons ou d'un détecteur UHF. Bien souvent, on utilisera plusieurs détecteurs 5 par paroi. Les détecteurs 5 sont connectés à des moyens d'acquisition et de traitement 6 des signaux reçus par eux. Les moyens d'acquisition et de traitement 6 incluent au moins des moyens de conversion analogique, des moyens d'enregistrement des signaux numérisés, des moyens de calcul permettant de faire une analyse de spectre, des moyens de filtrage. Les moyens d'acquisition et de traitement 6 peuvent comporter des moyens d'affichage 6.1. Les références 3 et 4 illustrent respectivement des traversées à haute tension et à basse tension reliées au transformateur et qui traversent l'enceinte 2. La référence S illustre une source de décharge partielle, l'apparition de la décharge partielle correspondant à l'événement recherché.

On a repéré sur la figure 1 par l'ovale, le front d'onde traduisant l'événement recherché qui est dans l'exemple traité une la décharge partielle. Mais le signal acquis par le détecteur est bruité et antérieurement à l'apparition de la décharge partielle, on a repéré par des flèches des pics de bruit à basse fréquence qui pourraient être pris pour la décharge partielle lors de sa recherche par des procédés connus comme ceux décrits par exemple dans les deux brevets cités antérieurement.

On va maintenant expliquer le procédé de détection de la position d'un front d'onde traduisant l'apparition d'un événement recherché selon l'invention. On commence par traiter le signal délivré par le détecteur. On le numérise d'une part à l'aide d'un convertisseur analogique numérique relié au détecteur. On va se servir plusieurs fois du signal de travail et on prévoit donc de l'enregistrer. Ce signal numérique sera par la suite appelé signal de travail.

En effet, l'idée de base de la présente invention est de filtrer plusieurs fois le signal de travail avec un filtre passe-bande dont on fait varier la largeur de la bande passante, les bandes passantes utilisées pour ces étapes de filtrage étant imbriquées les unes dans les autres. Nous allons expliquer maintenant comment déterminer les bandes passantes du filtre passe-bande.

On commence à l'aide d'un analyseur de spectre par calculer la transformée de Fourier discrète du signal de travail en utilisant par exemple la transformée de Fourier rapide. La transformée de Fourier rapide (connue en anglais par le sigle FFT pour Fast Fourier Transform) est un algorithme de calcul permettant de transformer un signal numérique fonction du temps en un signal numérique fonction de la fréquence. On se réfère à la figure 2A qui montre l'allure du signal correspondant à la transformée de Fourier discrète obtenue. Cette transformée de Fourier discrète comporte N1 échantillons. N1 est un nombre entier. L'homme du métier qui cherche à détecter la survenue d'une décharge partielle à partir de ce signal s'aperçoit que le premier pic apparaissant à basse fréquence est vraisemblablement du bruit.

Il est préférable pour s'affranchir de tels bruits de lisser le signal correspondant à la transformée de Fourier discrète obtenue. Le lissage peut se faire en transformant chaque échantillon parmi les N1 échantillons de la transformée de Fourier discrète en la moyenne des M échantillons qui le précède et des M échantillons qui le suit. M est un nombre entier non nul et peut valoir par exemple entre environ 10 et 30 selon la fréquence d'échantillonnage du signal correspondant à la transformée de Fourier discrète et donc selon la valeur de N1. Cette étape de lissage est optionnelle seulement. Dans la suite de la description, on va s'intéresser au signal lissé, mais on aurait très bien pu utiliser le signal non lissé.

Sur la figure 2B, on a représenté l'allure du signal correspondant à la transformée de Fourier discrète après lissage. On constate que le premier pic qui correspond à du bruit a été fortement réduit. On notera également sur ces deux figures 2A et 2B que les fréquences très basses inférieures à 1 kHz et très hautes supérieures à 500 kHz ont été supprimées, elles ne sont pas significatives dans l'application de détection des décharges partielles générées dans un appareil électrique.

On va ensuite fixer les bornes des bandes passantes extrêmes βmin, βmax du filtre passe-bande, c'est-à-dire les bornes de la plus étroite bande passante βmin et de la plus large bande passante βmax du filtre passe-bande. On va pour cela utiliser le signal correspondant à la transformée de Fourier discrète éventuellement lissée pour fixer ces bornes.

Nous nous référons à la figure 3. Pour déterminer les bornes de la bande passante la plus étroite βmin, on sélectionne dans les N1 échantillons de la transformée de Fourier discrète et lissée telle que représentée à la figure 3, les N2 échantillons ayant la plus grande amplitude et on détermine à quelle fréquence ils correspondent. N2 est un nombre entier, inférieur à N1. Cela peut être une fraction de N1. Si N1 vaut par exemple 5000, N2 peut valoir par exemple 1/20 ème soit 250. Dans ces N2 échantillons, on sélectionne la fréquence la plus grande et la plus petite, la plus petite fréquence forme la borne basse B2 de la bande passante la plus étroite βmin et la plus grande fréquence forme la borne haute B3 de la bande passante la plus étroite βmin.

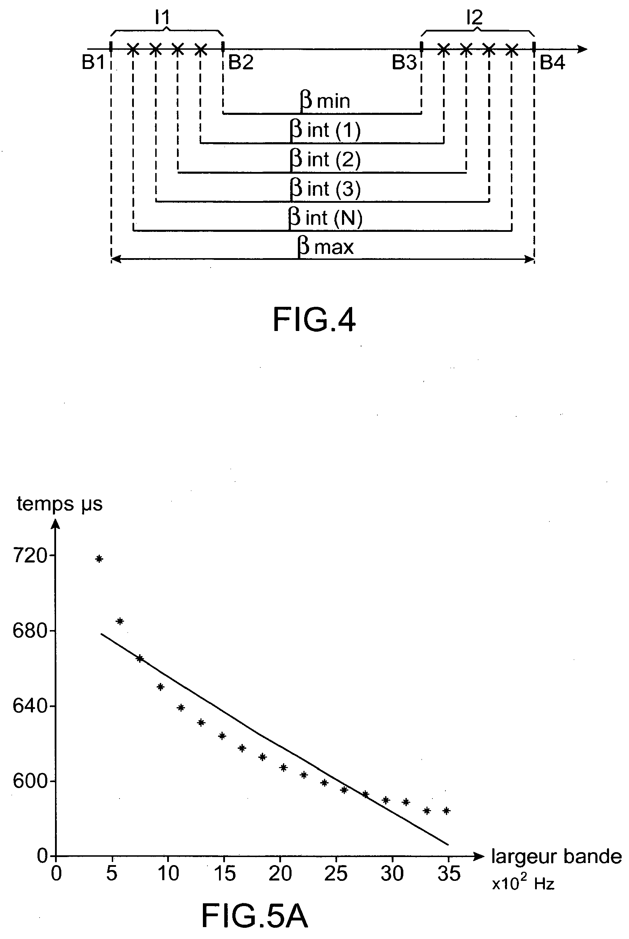

Pour déterminer les bornes de la bande passante la plus large βmax, on sélectionne dans la représentation de la figure 3, les N3 échantillons ayant la plus grande amplitude et on détermine à quelle fréquence ils correspondent. N3 est un nombre entier inférieur au nombre total d'échantillons N1 du signal correspondant à la transformée de Fourier discrète et de plus N3 est très supérieur à N2. Dans l'exemple décrit, on peut choisir N3 dix fois plus grand que N2, soit N3 égal 2500. Dans ces N3 échantillons, on sélectionne la fréquence la plus grande et la plus petite, la plus petite fréquence forme la borne basse B1 de la bande passante la plus large βmax et la plus grande fréquence forme la borne haute B4 de la bande passante la plus large βmax. On se réfère à la figure 4 qui illustre l'étendue des bandes passantes extrêmes. On s'assure que les deux bandes passantes βmin, βmaux sont différentes, c'est à dire que les bornes basses B1 et B2 ne sont pas confondues et simultanément que les bornes hautes B3 et B4 ne sont pas confondues. Il est toutefois possible que les deux bandes passantes extrêmes βmin, βmax aient une borne basse commune ou bien une borne haute commune. En fait la bande passante la plus étroite βmin est contenue dans la bande passante la plus large βmaux. Les deux bandes passantes extrêmes βmin, βmax peuvent être disjointes ou avoir une unique borne commune mais pas les deux. Les bornes B1, B2, B3, B4 doivent vérifier les inégalités suivantes : B1 inférieure ou égale à B2 et B3 strictement inférieure à B4 ou B1 strictement inférieure à B2 et B3 inférieure ou égale à B4. On doit donc vérifier deux conditions à savoir que la bande passante la plus large βmaux et la bande passante la plus étroite βmin ont au moins une borne basse B1, B2 ou une borne haute distincte B3, B4 et que la bande passante la plus étroite βmin soit contenue dans la bande passante la plus large βmaux, si ce n'est pas le cas, on décale l'une des bornes de la bande passante la plus étroite ou de la bande passante la plus large pour satisfaire aux deux conditions.

On va donc filtrer le signal de travail N4 fois, N4 est un nombre entier supérieur ou égal à trois. On va obtenir N4 signaux de travail filtrés. On filtre le signal de travail deux fois avec un filtre passe-bande dont la bande passante vaut d'une part βmin et d'autre part βmaux. On obtient alors deux signaux filtrés.

Mais on définit de plus, pour obtenir les N4 signaux de travail filtrés avec N4 supérieur ou égal à trois, une ou plusieurs bandes passantes intermédiaires βint (1), βint (2) ,....... βint (N) contenues les unes dans les autres de la plus étroite βint(1) à la plus large βint (N) lorsqu'il y en a plusieurs. Lorsque il y en a qu'une, la bande passante intermédiaire βint(1) est contenue dans la bande passante extrême la plus large βmax et contient la bande passante extrême la plus étroite βmit.

Pour définir les bornes extrêmes des bandes passantes intermédiaires βint (1), βint(2), βint (N), il suffit subdiviser en N+1 parties l'intervalle I1 existant entre les bornes basses B1, B2 des deux bandes passantes extrêmes βmin, βmax et/ou en N+1 parties, l'intervalle I2 existant entre les bornes hautes B3, B4 des deux bandes passantes extrêmes βmin, βmaux. N est un nombre entier supérieur ou égal à deux. Cette subdivision ne se fait bien sûr que si l'intervalle I1 ou l'intervalle I2 existe. Si les bandes passantes extrêmes βmin, βax ont une borne commune, l'intervalle correspondant est nul.

Une interface existe entre deux parties voisines du premier intervalle I1, cette interface formant une borne basse d'une bande passante intermédiaire et une interface existe entre deux parties voisines du second intervalle I2, cette interface formant une borne haute d'une bande passante intermédiaire. Les interfaces sont repérées par des croix sur la figure 4.

Les parties d'un même intervalle I1 ou I2 peuvent être égales ou non. Si les intervalles I1 et I2 sont inégaux, et que les parties du premier intervalle I1 sont égales et que les parties du second intervalle I2 sont égales, cela revient à dire que l'on augmentera la bande passante extrême la plus étroite βmin du côté de sa borne basse B2 d'un pas p1 et du côté de sa borne haute d'un pas p2 pour balayer les bandes passantes intermédiaires.

En finale, on dispose donc de N4 bandes passantes avec N4= N+2, c'est-à-dire les deux extrêmes βmax, βmin et les N intermédiaires βint (1), βint(2) ,........ βint (N).

Le nombre N4 sera choisi, de préférence, le plus grand possible pour disposer d'un plus grand nombre de bandes passantes pour le filtrage. Il faut prendre en compte toutefois, le fait que plus N4 sera grand, plus le temps de calcul sera grand. Pour le choix de N4, il faut également prendre en compte la puissance du calculateur dont on dispose. Le nombre N4 peut par exemple être égal à 20 dans le cas illustré sur la figure 4.

On va donc filtrer le signal de travail N4 fois avec un filtre passe-bande dont la bande passante varie de βmin à βmax en passant par βint (1), βint(2) ,........ βint(N). Le filtrage peut se faire aussi bien de la plus petite bande passante à la plus grande passante ou à l'inverse de la plus grande à la plus petite, le but est d'effectuer le filtrage avec les N4 bandes passantes.

On obtient donc N4 signaux filtrés à partir desquels on va déduire la position du front d'onde correspondant à l'événement recherché.

A chacun de ces N4 signaux filtrés, on va appliquer une méthode de recherche de position de front d'onde conventionnelle, ce qui revient à dire une méthode de recherche de pic dans un signal temporel. Cette méthode utilise généralement un indicateur et un seuil dépendant du signal de travail filtré. On peut utiliser, par exemple celle exposée dans la demande de brevet FR 2 883 979 à laquelle on pourra se référer. Cette méthode est basée sur le fenêtrage du signal filtré avec une fenêtre glissante, le calcul de l'énergie du signal dans la fenêtre glissante comportant un nombre optimal d'échantillons, le calcul de la moyenne quadratique de l'énergie, le seuillage de la moyenne quadratique avec un seuil fonction de la moyenne quadratique dans une fenêtre donnée. Dès que la moyenne quadratique dépasse pour la première fois le seuil, on a donc détecté la position du front d'onde. Cette position correspond à un instant d'apparition, c'est un temps, le signal qui sert à le trouver étant un signal temporel. D'autres méthodes de recherche de pics dans un signal temporel peuvent être utilisées, par exemple celle décrite dans le brevet US 5 388 445. Plus généralement, ces méthodes utilisent le fenêtrage du signal, la détermination d'un indicateur approprié au signal calculé dans chaque fenêtre et d'un seuil et une comparaison de l'indicateur et du seuil, un front d'onde étant détecté lorsque l'indicateur dépasse le seuil.

Une fois que la position du front d'onde a été identifiée dans chacun des N4 signaux de travail filtrés, on va vérifier si ces fronts d'ondes correspondent oui ou non à l'événement recherché et en déduire de manière la plus précise possible la position du front d'onde.

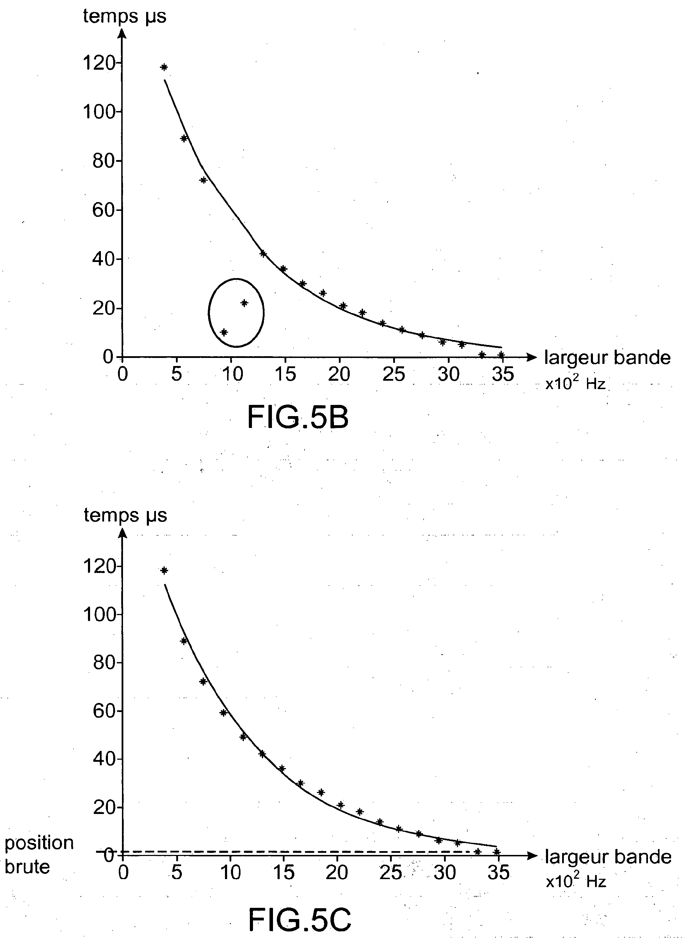

On fait correspondre à chaque position de front d'onde la largeur de la bande passante du filtre passe-bande utilisé. On obtient donc N4 points à placer dans un repère cartésien ayant comme ordonnée, la position du front d'onde, c'est-à-dire son instant d'apparition, et comme abscisse la largeur de bande. Si les N4 points correspondent au même front d'onde, ils vont s'inscrire sur ou quasiment sur une asymptote exponentielle. On peut se référer aux figures 5A, 5B, 5C.

En effet, le filtrage d'un signal numérique a pour effet de retarder le signal numérique filtré par rapport au signal numérique avant filtrage. Si le filtrage se fait avec un filtre passe-bande, le retard dû au filtrage varie de manière exponentielle avec la largeur de la bande passante du filtre.

On va donc rechercher à faire passer une asymptote exponentielle par le plus grand nombre de points possibles. L'asymptote exponentielle recherchée est une courbe décroissante qui tend vers l'infini pour les bandes passantes les plus étroites et vers zéro pour les bandes passantes les plus larges. Sur la figure 5A, les ordonnées varient sur une plage allant 580 à 720 microsecondes. Il peut être difficile de déterminer l'asymptote exponentielle, si en majorité les points déterminés ont une abscisse éloignée de zéro et donc de l'axe des ordonnées. Pour faciliter la recherche de l'asymptote, il est préférable de translater la plage de valeurs de l'axe des ordonnées, dans laquelle on trouve des points, vers l'axe des abscisses d'une grandeur dite de translation donnée. La figure 5B illustre cette variante, la grandeur de translation vaut ici 600 microsecondes. L'ancienne ordonnée 600 microsecondes correspond maintenant à 0 seconde. Pour choisir la grandeur de translation, il suffit que le point qui a la plus petite ordonnée, ait, après la translation, une ordonnée presque nulle mais pas nulle.

On remarque sur la figure 5B que deux points ne s'inscrivent pas sur l'asymptote exponentielle sur laquelle sont regroupés les autres points. Cela signifie que ces points sont dépendants du bruit et non pas d'un signal filtré qui se déplace exponentiellement en fonction de la largeur de la bande passante du filtre passe-bande employé. Ces deux points sont donc à éliminer, c'est ce qui a été fait sur la figure 5C.

A partir de cette représentation, la position du front d'onde correspondant à l'événement recherché est l'ordonnée du point se trouvant sur ou à proximité de l'asymptote exponentielle et dont l'abscisse est maximale et correspond donc à la plus grande bande passante. Le retard apporté par le filtrage est alors minimum. On s'aperçoit que le retard induit par le filtrage est négligeable. Bien sûr dans l'art antérieur, ce retard n'existait pas. Mais dans le procédé selon l'invention, on est sûr que le front d'onde identifié correspond à l'événement recherché alors que dans l'art antérieur, le front d'onde identifié pouvait sans que l'on s'en aperçoive correspondre à du bruit.

En fait la position détectée est une position brute, si l'on a effectué une translation des points. Sur la figure 5C, la position brute correspond à 2 microsecondes. Les deux derniers points dont l'ordonnée est proche de zéro sont trop éloignés de l'asymptote exponentielle et ne sont pas retenus. Il est bien entendu que, si pour rechercher l'asymptote exponentielle, on a effectué une translation, il faut corriger l'ordonnée trouvée, c'est-à-dire la position brute, et lui rajouter la grandeur de translation pour obtenir la position recherchée. La position recherchée correspond alors à l'instant 602 microsecondes.

Afin de faciliter la recherche de l'asymptote exponentielle, dans la mesure où l'on a utilisé un grand nombre de bandes-passantes pour le filtrage et que le nombre N4 est important (par exemple plusieurs centaines), on peut effectuer au préalable à la recherche de l'asymptote exponentielle, une vérification de l'ordonnée de chaque point par rapport à celle de ses voisins les plus proches d'une part celui qui le précède et d'autre part celui qui le suit sur l'axe de abscisses. On donne un rang à chaque point compris entre 1 et N4, le point ayant le rang 1 ayant la plus petite abscisse et le point de rang N4 ayant la plus grande abscisse. On vérifie donc que dans un triplet de points d'ordre P-1, P, P+1 ayant des abscisses successives, les trois points du triplet ont bien des ordonnées décroissantes, c'est-à-dire qu'un point intermédiaire de rang P compris entre 2 et N4 a bien une ordonnée inférieure à celle du point qui le précède de rang P-1 sur l'axe des abscisses et une ordonnée supérieure à celle du point qui le suit de rang P+1 sur l'axe de abscisses. Si ce n'est pas le cas, cela signifie qu'un des trois points du triplet casse la décroissance des ordonnées et on l'élimine. On recommence de proche en proche, avec le triplet des points de rang P, P+1, P+2 ou bien avec le triplet P-2, de rang P-1, P. Plus généralement, on utilise un autre triplet ayant deux points communs du triplet précédent ou éventuellement un seul si on a éliminé un point après la vérification. On continue ces vérifications successives jusqu'au dernier point, en éliminant tout point d'un triplet qui ne satisfait pas à la condition de décroissance des ordonnées, alors que les abscisses sont croissantes.

Il faut cependant veiller à ce qu'il reste, en final, un nombre N5 (nombre entier) suffisant de points pour calculer l'asymptote exponentielle, ce nombre N5 étant supérieur ou égal à N4/2. Au cas où, après vérification des ordonnées des points pris deux par deux, il ne reste pas suffisamment de points, cela signifie que l'on n'a pas prévu suffisamment de bandes passantes lors du filtrage et il faut en rajouter.

Avec le procédé selon l'invention, on vérifie donc que les fronts d'ondes détectés sur le signal de travail filtré ne correspondent pas à du bruit mais bien à l'événement recherché. C'est le filtrage avec les différentes bandes passantes qui permet d'éliminer des bruits parasites, la recherche de l'asymptote exponentielle permettant d'en éliminer encore d'autres.

Si l'on effectue l'étape de comparaison de l'ordonnée de deux points voisins, on simplifie le calcul de l'asymptote exponentielle et on élimine encore mieux l'influence de bruits parasites sur le calcul de l'asymptote.

Le procédé de détermination objet de l'invention consomme plus de temps que les procédés de l'art antérieur puisqu'il faut réitérer N4 fois le filtrage et qu'il faut déterminer l'asymptote exponentielle. Mais le résultat obtenu est beaucoup plus sûr que par le passé.

On va maintenant montrer trois allures de signaux de travail numérisés issus d'une mesure faite par un détecteur acoustique dans un appareil électrique tel un transformateur. Sur la figure 6A, la mesure est faite sur un site d'exploitation, sur la figure 6B la mesure est faite en usine et sur la figure 6C la mesure est faite en laboratoire. Ces signaux sont de moins en moins bruités. On a repéré par une flèche en trait plein la position du front d'onde détectée par un procédé classique de détection de front d'onde, le signal de travail ayant été filtré une seule fois avec un filtre passe-bande.

Le front d'onde détecté et illustré sur la figure 6A avec un trait plein ne correspond pas à l'événement recherché (une décharge partielle). L'événement recherché apparait à l'instant repéré par les traits pointillés. Le procédé classique ne permet donc pas de détecter l'arrivée de la décharge partielle. Sur la figure 6B, les mêmes conclusions s'imposent. Les deux milieux sont trop bruités pour que l'outil employé pour la recherche automatique de front d'onde soit fiable. L'outil détecte un front d'onde antérieur, ce font d'onde est dû au bruit. La figure 6C est un zoom de la courbe de la figure 6B aux alentours du front d'onde détecté. Sur la figure 6D, on a représenté un signal de travail mesuré en laboratoire, dans une cage de Faraday, ce qui fournit un milieu épargné par le bruit extérieur à la cage. Selon les caractéristiques du signal, le procédé de l'art antérieur permet d'identifier la position du front d'onde correspondant à l'événement recherché ou ne le permet pas. Sur la figure 6D, la position détectée est fiable et elle ne l'est pas sur la figure 6E. Sur la figure 6E, le signal est très clair au début et l'indicateur utilisé dans le procédé conventionnel de détection de front d'onde est trop sensible. La moindre impulsion sera assimilée au front d'onde correspondant à l'événement recherché. Prendre un indicateur moins sensible poserait problème en cas de signal plus bruité ou ayant un front d'onde moins net comme sur la figure 6D.

Sur la figure 7A, on a représenté le signal de travail de la figure 6A auquel on a appliqué le procédé selon l'invention avec un filtrage multiple itératif. Le front d'onde détecté correspond bien à l'événement recherché et pas à du bruit. Sa position est repérée par la flèche verticale. On a effectué le filtrage 9 fois comme illustré sur les figures 7B1 à 7B9. La bande passante du filtre passe-bande utilisé a été réduite petit à petit de la figure 7B1 à la figure 7B9. Les positions détectées ne sont pas satisfaisantes sur les figures 7B1, 7B2, 7B7. On comprend qu'au début, le signal est peu filtré (figures 7B1, 7B2) mais on s'aperçoit que le résultat n'est pas toujours satisfaisant avec un filtre plus étroit donné (figure 7B7) :

La figure 7C montre la position du front d'onde obtenue par le procédé de l'invention avec neuf filtrages itératifs à partir du signal de travail de la figure 6B mesuré en usine.

La détection est bien plus fiable. On remarque que la position détectée est légèrement en retard par rapport à celle indiquée en pointillés sur la figure 6B. Le retard est dû au filtrage et il est négligeable.

Les figures 7D et 7E reprennent les signaux des figure 6D et 6E. Dans ces deux cas la solution avec le filtrage itératif donne des résultats très satisfaisants.

Dans les cas où le procédé conventionnel donnait des résultats satisfaisants comme à la figure 6D, le procédé selon l'invention conduit à une détection sans retard ou pratiquement sans retard car tous les points détectés lors des différents filtrages seront inscrits sur l'asymptote exponentielle.

On comprendra que différents changements et modifications puissent être apportés aux exemples décrits sans sortir du cadre de l'invention tel que définie dans les revendications. Notamment d'autres méthodes de recherche de pics peuvent être utilisées. Les valeurs des nombres M, N, N1, N2, N3, N4 données ne sont pas limitatives, elles peuvent bien entendu être changées en fonction des échantillons de signal pris en compte.

## Revendications

1. Procédé de détection de la position d'un front d'onde traduisant l'apparition d'un évènement recherché dans un signal temporel reçu par un détecteur dans lequel :
- on numérise le signal reçu par le détecteur pour obtenir un signal de travail,
- on filtre le signal de travail N4 fois, N4 étant un nombre entier supérieur ou égal à trois, avec un filtre passe-bande en faisant varier la largeur de la bande passante du filtre passe-bande, les N4 bandes passantes étant contenues les unes dans les autres de la plus large à la plus étroite, de manière à obtenir N4 signaux de travail filtrés,
- on traite chacun des N4 signaux de travail filtrés avec une méthode de détection de pics pour détecter, pour chacun, une position d'un premier front d'onde en termes d'instant d'arrivée,
- on associe à chaque instant d'arrivée la largeur de la bande passante avec laquelle le signal de travail a été filtré,
- on définit N4 points ayant chacun une ordonnée qui est un des instants d'arrivée et une abscisse qui est la largeur de la bande associée,
- on place les N4 points dans un repère cartésien,
- on recherche une asymptote exponentielle dans laquelle s'inscrit un maximum des N4 points, la position du front d'onde traduisant l'apparition de l'événement recherché étant l'ordonnée d'un point qui se trouve sur ou quasiment sur l'asymptote exponentielle et qui possède l'abscisse la plus grande.

2. Procédé selon la revendication 1, dans lequel on calcule une transformée de Fourier discrète possédant N1 échantillons du signal de travail, N1 étant un nombre entier, et on l'utilise pour définir les bornes (B2, B3) de la bande passante la plus étroite (βmin) et les bornes (B1, B4) de la bande passante la plus large (βmax).

3. Procédé selon la revendication 2, dans lequel :
• pour définir les bornes (B2, B3) de la bande passante la plus étroite (βmin):
- on sélectionne dans la transformée de Fourier discrète les N2 échantillons ayant la plus grande amplitude, N2 étant un nombre entier inférieur à N1,
- on attribue à la bande passante la plus étroite (βmin) une borne basse (B2) qui est la fréquence la plus basse des N2 échantillons et une borne haute (B3) qui est la fréquence la plus haute des N2 échantillons, et
• pour définir les bornes de la bande passante la plus large (βmax):
- on sélectionne dans la transformée de Fourier discrète les N3 échantillons ayant la plus grande amplitude, N3 étant un nombre entier bien plus grand que N2 mais inférieur à N1,
- on attribue à la bande passante la plus large (βmax) une borne basse (B1) qui est la fréquence la plus basse des N3 échantillons et une borne haute (B4) qui est la fréquence la plus haute des N3 échantillons, et
• on vérifie deux conditions à savoir que la bande passante la plus large (βmax) et la bande passante la plus étroite (βmin) ont au moins une borne basse (B1, B2) ou une borne haute (B3, B4) distincte et que la bande passante la plus étroite (βmin) soit contenue dans la bande passante la plus large (βmax), si ce n'est pas le cas, on décale au moins l'une des bornes (B1, B2, B3, B4) de la bande passante la plus étroite (βmin) et/ou de la bande passante la plus large(βmax) pour satisfaire aux deux conditions.

4. Procédé selon l'une des revendications 2 à 3, dans lequel on lisse la transformée de Fourier discrète avant de définir les bornes (B2, B3) de la bande passante la plus étroite (βmin) et les bornes (B1, B4) de la bande passante la plus large (βmaux).

5. Procédé selon l'une des revendications 2 à 4, dans lequel on définit une ou plusieurs bandes passantes intermédiaires (βint (1), βint(2)) contenues les unes dans les autres en subdivisant un premier intervalle (I1), s'il existe, entre la borne basse (B1) de la bande passante la plus large (βmax) et la borne basse (B2) de la bande passante la plus étroite (βmin) en N+1 parties, N étant un entier supérieur ou égal a un, et/ou en subdivisant un second intervalle (I2), s'il existe, entre la borne haute (B4) de la bande passante la plus large (βmax) et la borne haute (B3) de la bande passante la plus étroite (βmin) en N+1 parties, une interface existant entre deux parties voisines du premier intervalle (I1), cette interface formant une borne basse d'une bande passante intermédiaire (βint(1)) et une interface existant entre deux parties voisines du second intervalle (I2), cette interface formant une borne haute d'une bande passante intermédiaire (βint(1)).

6. Procédé selon l'une des revendications 1 à 5, dans lequel lors du placement des N4 points dans le repère cartésien, on translate l'ordonnée des N4 points d'une grandeur de manière à ce que le point, ayant l'ordonnée la plus petite, ait une ordonnée presque nulle après translation.

7. Procédé selon la revendication 6, dans lequel on corrige la position du front d'onde correspondant à l'événement recherché en lui ajoutant la grandeur de translation.

8. Procédé selon l'une des revendications précédentes, dans lequel, avant l'étape de recherche d'asymptote, on sélectionne des points d'un triplet de points ayant des abscisses successives croissantes, on vérifie si les ordonnées de ces trois points sont bien décroissantes, si un des points du triplet ne vérifie pas cette décroissance en ordonnée on l'élimine et on réitère cette vérification de proche en proche avec un triplet suivant ayant au moins un point du triplet précédent.

9. Procédé selon la revendication 8, dans lequel on arrête la comparaison dès que le nombre de points éliminés atteint N4/2.

10. Procédé selon l'une des revendications 1 à 9, dans lequel l'événement recherché est une décharge partielle émise par une source de décharge partielle (S) se trouvant dans un appareil électrique (1) placé dans une enceinte (2) contenant un fluide acoustiquement conducteur, le détecteur (5) étant un détecteur acoustique.

## Patentansprüche

1. Verfahren zum Detektieren der Position einer Wellenfront, die auf das Auftreten eines gewünschten Ereignisses zurückzuführen ist, bei einem von einem Sensor empfangenen Zeitsignal, wobei:
- das von dem Sensor empfangene Signal digitalisiert wird, um ein Arbeitssignal zu erhalten,
- das Arbeitssignal mit einem Bandpassfilter N4 mal gefiltert wird, wobei N4 eine ganze Zahl größer oder gleich drei ist, indem die Bandbreite des Durchlassbandes des Bandpassfilters verändert wird, wobei die N4 Durchlassbänder ausgehend vom breitesten bis hin zum schmälsten Band ineinander enthalten sind, so dass N4 gefilterte Arbeitssignale erhalten werden,
- jedes der N4 gefilterten Arbeitssignale mit einem Spitzenerkennungsverfahren verarbeitet werden, um für jedes eine Position einer ersten Wellenfront bezüglich der Ankunftszeit zu detektieren,
- jeder Ankunftszeit die Bandbreite des Durchlassbandes zugeordnet wird, mit der das Arbeitssignal gefiltert wurde,
- N4 Punkte definiert werden, die jeweils eine Ordinate haben, die eine der Ankunftszeiten ist, sowie eine Abszisse, die die Bandbreite des zugeordneten Bandes ist,
- die N4 Punkte in ein kartesisches System gesetzt werden,
- eine exponentielle Asymptote gesucht wird, in die sich ein Maximum von N4 Punkten einbeschreibt, wobei die Position der Wellenfront, die auf das Auftreten des gewünschten Ergebnisses zurückzuführen ist, die Ordinate eines Punktes ist, der auf oder quasi auf der exponentiellen Asymptote liegt und der die größte Abszisse besitzt.

2. Verfahren nach Anspruch 1, wobei eine diskrete Fourier-Transformierte berechnet wird, die N1 Abtastwerte des Arbeitssignals besitzt, wobei N1 eine ganze Zahl ist, und sie dazu verwendet wird, um die Grenzen (B2, B3) des schmalsten Durchlassbandes (βmin) und die Grenzen (B1, B4) des breitesten Durchlassbandes (βmax) zu definieren.

3. Verfahren nach Anspruch 2, wobei
• zum Definieren der Grenzen (B2, B3) des schmalsten Durchlassbandes (βmin):
- in der diskreten Fourier-Transformierten die N2 Abtastwerte ausgewählt werden, die die größte Amplitude haben, wobei N2 eine ganze Zahl kleiner als N1 ist,
- dem schmalsten Durchlassband (βmin) eine Untergrenze (B2) zugeordnet wird, die die niedrigste Frequenz der N2 Abtastwerte ist, sowie eine Obergrenze (B3), die die höchste Frequenz der N2 Abtastwerte ist, und
• zum Definieren der Grenzen des breitesten Durchlassbandes (βmax):
- in der diskreten Fourier-Transformierten die N3 Abtastwerte ausgewählt werden, die die größte Amplitude haben, wobei N3 eine ganze Zahl deutlich größer als N2, aber kleiner als N1 ist,
- dem breitesten Durchlassband (βmax) eine Untergrenze (B1) zugeordnet wird, die die niedrigste Frequenz der N3 Abtastwerte ist, sowie eine Obergrenze (B4), die die höchste Frequenz der N3 Abtastwerte ist, und
• zwei Bedingungen erfüllt werden, nämlich dass das breiteste Durchlassband (βmax) und das schmalste Durchlassband (βmin) zumindest eine Untergrenze (B1, B2) bzw. eine sich davon unterscheidende Obergrenze (B3, B4) haben und dass das schmalste Durchlassband (βmin) in dem breitesten Durchlassband (βmax) enthalten ist; falls das nicht zutrifft, wird zumindest eine der Grenzen (B1, B2, B3, B4) des schmalsten Durchlassbandes (βmin) und/oder des breitesten Durchlassbandes (βmax) versetzt, um die beiden Bedingungen zu erfüllen.

4. Verfahren nach einem der Ansprüche 2 bis 3, wobei die diskrete Fourier-Transformierte geglättet wird, bevor die Grenzen (B2, B3) des schmalsten Durchlassbandes (βmin) und die Grenzen (B1, B4) des breitesten Durchlassbandes (βmax) definiert werden.

5. Verfahren nach einem der Ansprüche 2 bis 4, wobei ein oder mehrere Zwischendurchlassbänder (βint(1), βint(2)) definiert werden, die ineinander enthalten sind, indem - wenn vorhanden - ein erstes Intervall (I1) zwischen der Untergrenze (B1) des breitesten Durchlassbandes (βmax) und der Untergrenze (B2) des schmalsten Durchlassbandes (βmin) in N+1 Teile aufgeteilt wird, wobei N eine ganze Zahl größer oder gleich eins ist, und/oder indem - wenn vorhanden - ein zweites Intervall (I2) zwischen der Obergrenze (B4) des breitesten Durchlassbandes (βmax) und der Obergrenze (B3) des schmalsten Durchlassbandes (βmin) in N+1 Teile aufgeteilt wird, wobei eine Schnittstelle zwischen zwei benachbarten Teilen des ersten Intervalls (I1) besteht, wobei diese Schnittstelle eine Untergrenze eines Zwischendurchlassbandes (βint(t)) bildet, und wobei eine Schnittstelle zwischen zwei benachbarten Teilen des zweiten Intervalls (I2) besteht, wobei diese Schnittstelle eine Obergrenze eines Zwischendurchlassbandes (βint(t)) bildet.

6. Verfahren nach einem der Ansprüche 1 bis 5, wobei beim Setzen der N4 Punkte in das kartesische System die Ordinate der N4 Punkte um eine Größe so verschoben wird, dass der Punkt mit der kleinsten Ordinate nach der Verschiebung eine Ordinate von fast null aufweist.

7. Verfahren nach Anspruch 6, wobei die Position der Wellenfront korrigiert wird, die dem gewünschten Ereignis entspricht, indem dieser die Größe der Verschiebung hinzugefügt wird.

8. Verfahren nach einem der vorangehenden Ansprüche, wobei vor dem Schritt der Suche nach der Asymptote Punkte einer Dreiergruppe von Punkten ausgewählt werden, die aufeinanderfolgende, ansteigende Abszissen haben, wobei überprüft wird, ob die Ordinaten dieser drei Punkte abfallend sind und - falls einer der Punkte der Dreiergruppe dieses Abfallen der Ordinaten nicht erfüllt - er entfernt wird und diese Überprüfung nach und nach mit einer nächsten Dreiergruppe wiederholt wird, die zumindest einen Punkt der vorherigen Dreiergruppe aufweist.

9. Verfahren nach Anspruch 8, wobei der Vergleich abgebrochen wird, sobald die Anzahl an entfernten Punkt N4/2 erreicht.

10. Verfahren nach einem der Ansprüche 1 bis 9, wobei das gewünschte Ereignis eine Teilentladung ist, die von einer Teilentladungsquelle (S) emittiert wird, die sich in einem elektrischen Gerät (1) befindet, das in einem Behälter (2) angeordnet ist, der ein schallleitendes Fluid enthält, wobei der Sensor (5) ein Schallsensor ist.

## Claims

1. A method of detecting the position of a wavefront reflecting the occurrence of a looked-for event in a time-varying signal received by a detector, wherein:
the signal received by the detector is digitized to produce a working signal;
the working signal is filtered N4 times, N4 being an integer greater than or equal to 3, with a band-pass filter, while varying times the width of the pass-band of the band-pass filter, the N4 pass-bands being contained one within another from the widest to the narrowest, to obtain N4 filtered working signals;
each of the N4 filtered working signals is processed by a peak detection method to detect in each signal the position of a first wavefront in terms of time of occurrence;
the width of the pass-band with which the working signal was filtered is associated with each time of occurrence;
N4 points are defined each having an ordinate that is one of the times of occurrence and an abscissa that is the width of the associated band;
the N4 points are placed in a Cartesian system of axes; and
a search is made for an exponential asymptote that fits a maximum number of the N4 points, the position of the wavefront reflecting the occurrence of the looked-for event being the ordinate of a point that has the largest abscissa and is on or virtually on the exponential asymptote.

2. A method according to claim 1, wherein a discrete Fourier transform is calculated using N1 samples of the working signal, N1 being an integer, and used to define the bounds (B2, B3) of the narrowest pass-band (βmin) and the bounds (B1, B4) of the widest pass-band (βmax).

3. A method according to claim 2, wherein:
to define the bounds (B2, B3) of the narrowest pass-band (βmin) :
the N2 samples having the greatest amplitude are selected in the discrete Fourier transform, N2 being an integer less than N1;
the narrowest pass-band (βmin) is assigned a lower bound (B2) that is the lowest frequency of the N2 samples and an upper bound (B3) that is the highest frequency of the N2 samples; and
to define the bounds of the widest pass-band (βmax):
the N3 samples having the greatest amplitude are selected in the discrete Fourier transform, N3 being an integer much greater than N2 but less than N1;
the widest pass-band (βmax) is assigned a lower bound (B1) that is the lowest frequency of the N3 samples and an upper bound (B4) that is the highest frequency of the N3 samples; and
two conditions are verified, namely that the widest pass-band (βmax) and the narrowest pass-band (βmin) have at least one lower bound (B1, B2) or one upper bound (B3, B4) that is different, and that the narrowest pass-band (βmin) is contained within the widest pass-band (βmax); if this is not so, at least one of the bounds (B1, B2, B3, B4) of the narrowest pass-band (βmin) and/or of the widest pass-band (βmax) is shifted so that the two conditions are satisfied.

4. A method according to claim 2 or claim 3, wherein the discrete Fourier transform is smoothed before defining the bounds (B2, B3) of the narrowest pass-band (βmin) and the bounds (B1, B4) of the widest pass-band (βmax).

5. A method according to any one of claims 2 to 4, wherein one or more intermediate pass-bands (βint(1), βint(2)) contained one within another are defined by subdividing a first interval (11), if it exists, between the lower bound (B1) of the widest pass-band (βmax) and the lower bound (B2) of the narrowest pass-band (βmin) into N + 1 parts, N being an integer greater than or equal to 1, and/or by subdividing a second interval (I2), if it exists, between the upper bound (B4) of the widest pass-band (βmax) and the upper bound (B3) of the narrowest pass-band (βmin) into N + 1 parts, an interface between two adjacent parts of the first interval (11) forming a lower bound of an intermediate pass-band (βint(1)) and an interface between two adjacent parts of the second interval (I2) forming an upper bound of an intermediate pass-band (βint(2)).

6. A method according to any one of claims 1 to 5, wherein when placing the N4 points in the Cartesian system of axes, the ordinates of the N4 points are moved in translation through a distance such that after the movement in translation, the point having the lowest ordinate has an ordinate of virtually zero.

7. A method according to claim 6, wherein the position of the wavefront corresponding to the looked-for event is corrected by adding the translation distance to it.

8. A method according to any preceding claim, wherein, before the asymptote search step, a triplet of points having successive increasing abscissas is selected, it is verified that the ordinates of these three points are decreasing, to discard any of the points of the triplet if it does not satisfy this decreasing ordinate condition, and this verification is repeated progressively with a next triplet including at least one point from the preceding triplet.

9. A method according to claim 8, wherein the comparison is stopped as soon as the number of points discarded reaches N4/2.

10. A method according to any one of claims 1 to 9, wherein, the detector (5) being an acoustic detector, the looked-for event is a partial discharge caused by a partial discharge source (S) in an electrical equipment (1) placed in an enclosure (2) containing an acoustically-conductive fluid.
